# EUROPEAN PATENT APPLICATION

(11) **EP 4 692 714 A1**
(43) Date of publication of application: **11.02.2026**
(21) Application number: 25193629.0
(22) Date of filing: 04.08.2025
(51) Int. Cl.: F28F 3/12, H01M 10/613, H01M 10/6554, H01M 10/6567, H01M 10/647, H01M 10/6557

(54) **LIQUID COOLING PLATE**

(30) Priority: 09.08.2024 CN 202421938898 U; 18.11.2024 WO PCT/CN2024/132616
(71) Applicant: Eve Energy Co., Ltd., Huizhou, Guangdong 516006 (CN)
(72) Inventor: HUANG, Liliang, Huizhou, Guangdong, 516006 (CN)
(74) Representative: Berggren Oy

(57) **Abstract**

The present disclosure discloses a liquid cooling plate, including a plate body (1), wherein the plate body (1) has a cavity forming a liquid cooling flow channel (11), wherein an elastic element (3) is installed in the liquid cooling flow channel (11), wherein one side of the elastic element (3) is attached to an inner wall of one side of the plate body (1), and the elastic element (3) protrudes in a direction away from the side of the inner wall that the elastic element (3) is attached to.

## Description

### TECHNICAL FIELD

The present disclosure relates to the field of battery technologies, and in particular to a liquid cooling plate.

### BACKGROUND

As electric vehicles (EVs) become more popular, the demand for fast charging technologies is growing. However, thermal management of battery packs during fast charging becomes a major challenge. High-current-charging not only generates a lot of heat, but is also accompanied by thermal expansion of batteries. The temperature of the battery rises during charging, causing it to expand in volume. This expansion behavior causes physical stress on the structure around the battery, especially the liquid cooling plate.

In order to alleviate the heating of battery packs, liquid cooling technologies is widely used in battery thermal management systems (BTMS). Liquid cooling plates, as key components of liquid cooling systems, are usually designed with internal hollow channels for the circulation of coolant to effectively reduce the temperature of the battery.

When the battery expands due to temperature rise during charging, the battery module will squeeze adjacent liquid cooling plates. The liquid cooling plate itself has a certain height. When subjected to external pressure, the liquid cooling plate is very likely to deform significantly, thereby affecting the heat dissipation effect of the liquid cooling plate on the battery.

### SUMMARY

In a first aspect, the present disclosure provides a liquid cooling plate for heat dissipation of battery cells, including a plate body, wherein the plate body has a cavity forming a liquid cooling flow channel, wherein an elastic element is installed in the liquid cooling flow channel, wherein one side of the elastic element is attached to an inner wall of one side of the plate body, and the elastic element protrudes in a direction away from the side of the inner wall that the elastic element is attached to.
1. One side of the elastic element is attached to the inner wall of the plate body, while the other side of the elastic element protrudes in a direction away from the side of the inner wall that the elastic element is attached to. When the liquid cooling flow channel is compressed by the expansion of the battery cell, the elastic element can absorb and alleviate the extrusion caused by the thermal expansion of the battery cell, thereby preventing the liquid cooling flow channel from plastic deformation. Even if a small amount of deformation occurs, the elastic element can release its own elastic potential energy to restore the liquid cooling flow channel to its original state.
2. By reducing the damage to the liquid cooling plate caused by the expansion of the battery cells, the reliability of the entire liquid cooling system is improved and the service life of the liquid cooling plate and its related components is extended.
3. By reducing the damage caused by battery cell expansion, the service life of the liquid cooling plate is extended, indirectly reducing long-term operating costs.

### BRIEF DESCRIPTION OF THE DRAWINGS

FIG. 1 is a three-dimensional structural schematic view of the present disclosure;
FIG. 2 is a cross-sectional structural schematic view of the elastic element of the present disclosure in form of rubber strip;
FIG. 3 is an enlarged view of portion A of FIG. 2;
FIG. 4 is a structural schematic view of the rubber strip of the present disclosure;
FIG. 5 is a cross-sectional structural schematic view of the elastic element of the present disclosure in form of an elastic sheet;
FIG. 6 is an enlarged view of portion B of FIG. 5;
FIG. 7 is a structural schematic view of the elastic sheet of the present disclosure.

Reference numerals in the drawings: 1. Plate body; 11. Liquid cooling flow channel; 12. First major surface; 13. Second major surface; 2. Assembly unit; 21. First positioning rib; 22. Second positioning rib; 3. Elastic element; 31. Rubber strip; 32. Elastic sheet; 33. Snap-fit groove; 4. Pressure relief plate; 41. Pressure relief channel; 42. Exhaust port; 5. Battery cell.

### DETAILED DESCRIPTION OF THE EMBODIMENTS

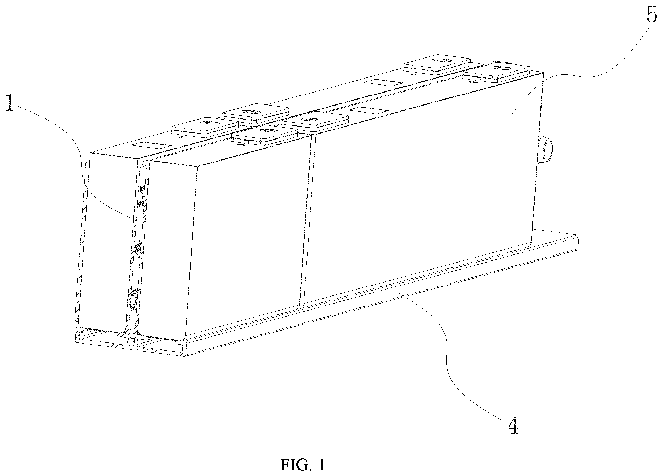

Referring to Figures 1 to 4, the present disclosure discloses a liquid cooling plate for heat dissipation of battery cells, including a plate body 1, wherein the plate body 1 has a cavity forming a liquid cooling flow channel 11, wherein an elastic element 3 is installed in the liquid cooling flow channel 11, wherein one side of the elastic element 3 is attached to an inner wall of one side of the plate body 1, and the elastic element 3 protrudes in a direction away from the side of the inner wall that the elastic element 3 is attached to.

In some embodiments, the plate body 1 is a hollow plate, and the hollow structure of the plate body 1 forms a liquid cooling flow channel 11. An elastic element 3 is provided in the hollow structure of the plate body 1, and one side of the elastic element 3 is attached to the inner wall of one side of the plate body 1, that is, a side surface of the elastic element 3 is attached to the inner wall of one side of the liquid cooling flow channel 11, and the elastic element 3 protrudes in a direction away from the side of the inner wall that the elastic element 3 is attached to. In addition, optionally, it can be configured whether elastic element 3 abuts against the two opposing inner walls that form the liquid cooling flow channel. In an embodiment, a side surface of the elastic element 3 is configured to be attached to the inner wall of one side of the plate body 1, and a gap is left between the other side of the elastic element 3 and the inner wall of the opposite side of the plate body 1, that is, when plate body 1 is subjected to compressive loading, once its elastic deformation reaches a critical degree, the elastic element 3 comes into contact with both opposing lateral walls of the plate body 1, thereby providing support to the plate body 1.

The elastic element 3 can be arranged on the top or bottom wall of the plate body 1, or on one of the two opposite lateral walls of the plate body 1, which is not limited here. The connection method between the elastic element 3 and the inner wall of the plate body 1 can be selected from welding, bonding, or abutment, etc., provided that it ensures elastic element 3 remains stationary within liquid cooling flow channel 11. The connection method between the elastic element 3 and the plate body 1 can be flexibly selected as required, which is not limited here.

In some embodiments, in order to improve the supporting effect of the elastic element 3 on the plate body 1 and expand the function of the elastic element 3, the elastic element 3 respectively abuts against two opposite inner walls of the plate body 1, which divides the liquid cooling flow channel 11 into two independent cavities.

In some embodiments, the elastic element 3 abuts against two opposite inner walls of plate body 1, which can not only improve the support for the cavity of the plate body 1, but also divide the liquid cooling flow channel 11 into two independent cavities, thereby facilitating the series/parallel setting of the liquid cooling flow channel 11 in the entire liquid cooling system.

In some embodiments, in order to facilitate the assembly of the elastic element 3, an assembly unit 2 is provided in the liquid cooling flow channel 11 of the plate body 1, and the assembly unit 2 includes two first positioning ribs 21. The two first positioning ribs 21 are arranged along the length direction of the liquid cooling flow channel 11, that is, along the flow direction of the coolant in the liquid cooling flow channel 11. The two first positioning ribs 21 are disposed on a same inner wall of the plate body 1 to facilitate the installation and positioning of the elastic element 3. The elastic element 3 is assembled between the two first positioning ribs 21, and the two first positioning ribs 21 is abutted against the elastic element 3 to facilitate the positioning of the elastic element 3. The elastic element 3 is respectively abutted against the inner wall where the first positioning ribs 21 are located and the opposite inner wall, so as to achieve the effect of the elastic element 3 supporting the liquid cooling flow channel 11.

In some embodiments, the plate body 1 is a hollow plate, and the hollow structure of the plate body 1 forms a liquid cooling flow channel 11. An assembly unit 2 is provided in the hollow structure of the plate body 1, and the assembly unit 2 includes two first positioning ribs 21. The two first positioning ribs 21 are arranged along the length direction of the liquid cooling flow channel 11, that is, the flow direction of the coolant in the liquid cooling flow channel 11. The two first positioning ribs 21 are arranged on the same side of the inner wall to facilitate the installation and positioning of the elastic element 3. The elastic element 3 is assembled between the two first positioning ribs 21, and the two first positioning ribs 21 are abutted against the elastic element 3 to facilitate the positioning of the elastic element 3. The elastic element 3 is respectively abutted against the inner wall where the first positioning ribs 21 are located and the opposite inner wall, so as to achieve the effect of the elastic element 3 supporting the liquid cooling flow channel 11.

By the above arrangement, two first positioning ribs are arranged on the same inner wall of the plate body 1 along the direction of the liquid cooling flow channel to provide fixation for the elastic element, and the elastic element is located between the two first positioning ribs. More importantly, the elastic element is assembled between the two first positioning ribs via a plug-in engagement method. After the liquid cooling plate is used for a long time, even if the elastic performance of the elastic element deteriorates, it can be repaired by replacing the elastic element alone without replacing the entire liquid cooling plate, thereby reducing the maintenance cost of the liquid cooling plate in this regard.

In some embodiments, the first positioning ribs 21 can be disposed on the top or bottom wall of the plate body 1, or on one of the two opposite lateral walls of the plate body 1, which is not limited here. In addition, the two first positioning ribs 21 are optimally arranged in parallel. In an alternative embodiment, the two first positioning ribs 21 can be disposed obliquely in relation to each other provided that they remain non-intersecting and allow insertion of the elastic member 3.

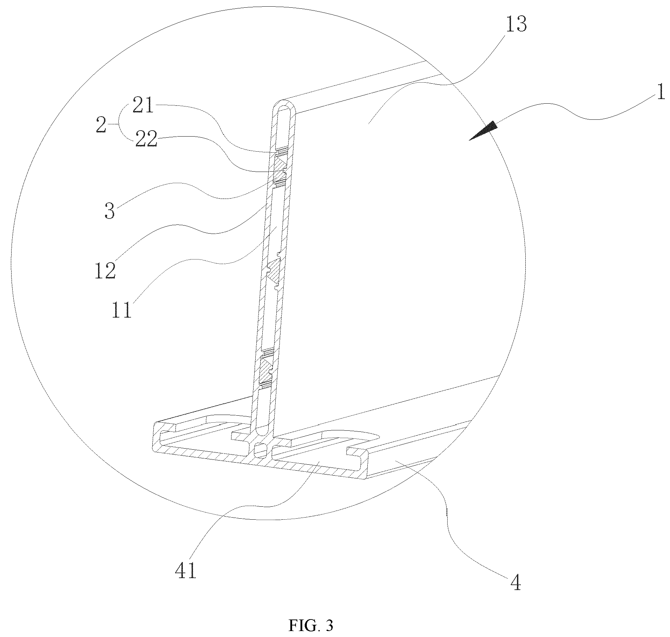

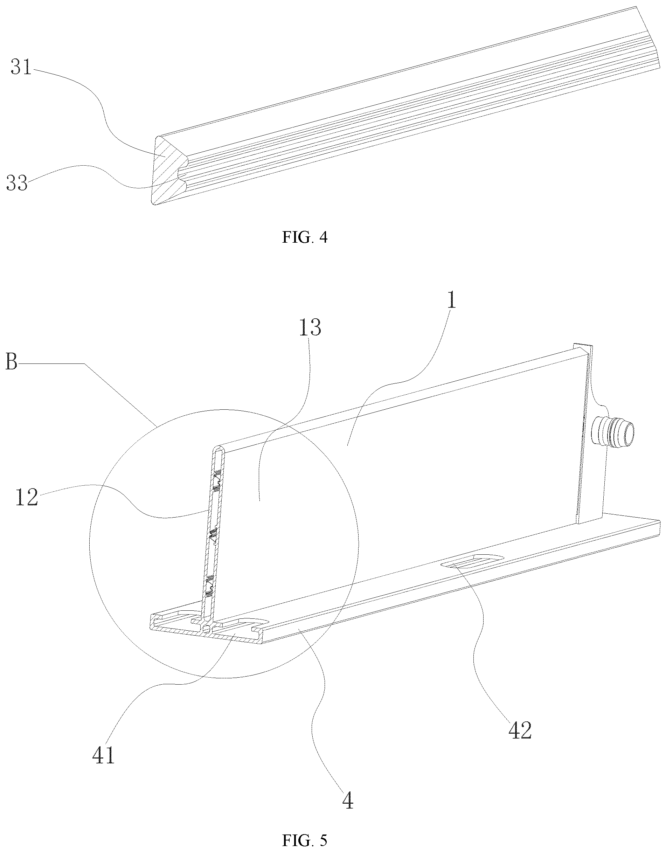

Referring to Figures 3 and 4, in some embodiments, the inner walls of the plate body 1 has a first major surface 12 and a second major surface 13 that are oppositely disposed relative to each other, and the two first positioning ribs 21 are both arranged on the first major surface 12 or the second major surface 13. Under operational loading, since the first major surface 12 and the second major surface 13 having larger surface areas compared to other surfaces of the plate body 1 are more susceptible to deformation than the other surfaces. Thus, it is more necessary to provide targeted support for the elastic element 3. Specifically, the first positioning rib 21 is arranged on the first major surface 12 or the second major surface 13. When the elastic element 3 is installed, it can abut between the first major surface 12 and the second major surface 13, thereby effectively supporting the first major surface 12 and the second major surface 13, mitigating deformation of the liquid cooling flow channel 11, and thus ensuring the flow efficiency of the liquid cooling flow channel 11.

In some embodiments, in order to ensure maximum utilization of the elastic element 3, vertical distance between the first major surface 12 and the second major surface 13 is set to B, thickness of the battery cell adjacent to the plate body 1 is T, the thickness of the battery cell is length of the battery cell defined along the direction of the vertical distance B, and the maximum height of the first positioning rib 21 is H, then the maximum height H is defined as: H=B-T*3%. By limiting the maximum height H of the first positioning rib 21, precise support from the liquid cooling plate during battery cell expansion is ensured, which prevents premature abutment of the first positioning rib 21 against its opposing inner wall before the elastic element 3 reaches its maximum energy absorption capacity, which is resulted from the high height of the first positioning rib 21, thereby affecting the absorption performance of the elastic element. In addition, it is possible that the premature abutment of the first positioning rib 21 against its opposing inner wall results in stress concentration, and even damage to the plate body 1.

Referring to Figures 3 and 4, in some embodiments, in order to ensure the positioning effect of the elastic element 3, the assembly unit 2 includes two first positioning ribs 21 and one second positioning rib 22, wherein the two first positioning ribs 21 is arranged on one of the first major surface 12 and the second major surface 13, while the second positioning rib 22 is arranged on the other one of the first major surface 12 and the second major surface 13. The second positioning rib 22 is staggeredly arranged with the two first positioning ribs 21. A snap-fit groove 33 is provided on the side of the elastic element 3 facing the second positioning rib 22, and the second positioning rib 22 is snap-fitted with the snap-fit groove 33.

In some embodiments, by staggeredly distributing the first positioning rib 21 and the second positioning rib 22 on the first major surface 12 and the second major surface 13, it is ensured that the elastic element 3 is maintained in a predefined load-bearing orientation during installation, thereby preventing plastic deformation of the elastic element 3 under external forces. The elastic element 3 is further provided with a snap-fit groove 33 on the side facing the second positioning rib 22, which is snap-fitted with the second positioning rib 22. This configuration can not only provide a certain guided effect during the installation of the elastic element 3, but more importantly, it can also ensure accurate repositioning of the elastic element 3 after being subjected to thermal expansion pressure from the battery cell. Consequently, the reliability and service life of the liquid cooling system are enhanced.

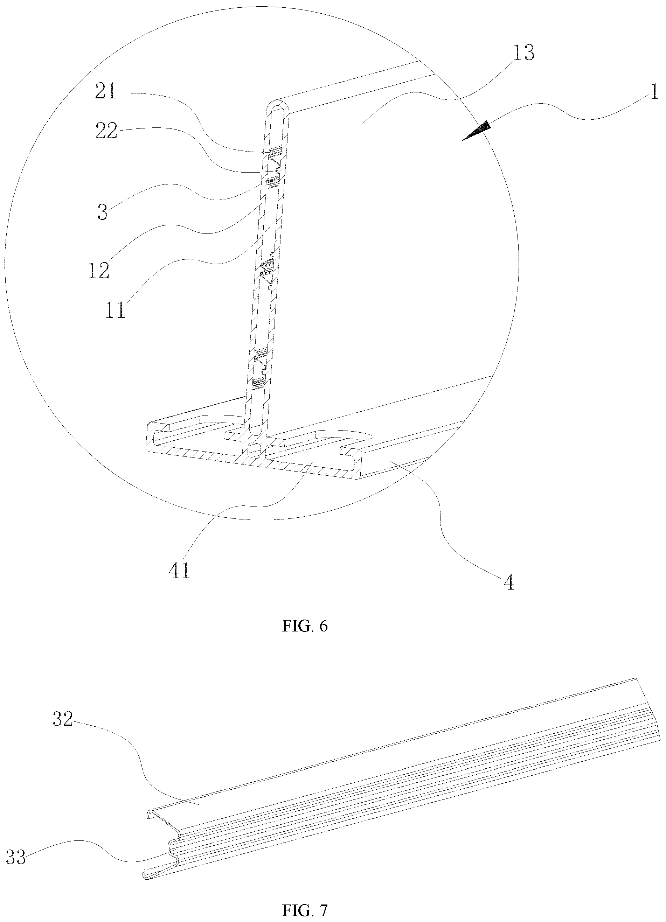

Referring to FIGS. 3 to 6, in some embodiments, in order to improve the stability and support of the elastic element 3, the second positioning rib 22 is equidistant from the two first positioning ribs 21, that is, the connecting lines between the centers of cross-sections of second positioning rib 22 and the two first positioning ribs 21 forms an isosceles triangle. This isosceles triangular configuration ensures the uniform distribution of the elastic element 3 in the liquid cooling plate, so that when the entire plate body 1 is subjected to the expansion pressure of the battery cell, the stress distribution of each part is more uniform, reducing local stress concentration and avoiding deformation or damage caused by uneven local force. In addition, the equidistant arrangement makes the replacement and maintenance of the elastic element 3 more standardized, and there is no need to design elastic elements 3 of various specifications for different spacing arrangement, which reduces maintenance costs and complexity.

In some embodiments, the second positioning rib 22 is arranged parallel to the first positioning rib 21, and in an alternative embodiment the second positioning rib 22 can also be oblique to the first positioning rib 21, provided that normal installation of the elastic element 3 and positioning of the elastic element 3 can be ensured.

Referring to Figures 3 and 5, in some embodiments, in order to improve the supporting effect on the liquid cooling flow channel 11, the inner wall of the plate body 1 is provided with a plurality of groups of assembly units 2 along the height direction of the plate body 1. By providing the plurality of groups of assembly units 2, when the liquid cooling plate is subjected to the expansion pressure of the battery cell, the pressure can be dispersed through the synergistic effect of the various positioning ribs and the elastic elements 3 to prevent the deformation of the liquid cooling flow channel 11, thereby maintaining the stability and cooling effect of the liquid cooling system.

In some embodiments, the plurality of groups of assembly units 2 can be arranged at equal spacing. Such an arrangement can improve the supporting effect of the elastic element 3 installed in the assembly unit 2 on the liquid cooling flow channel 11, enabling uniform distribution of externally applied pressure on the plate body 1. In addition, the distribution of the plurality of groups of assembly units can effectively reduce the damage to the liquid cooling plate caused by the expansion of the battery cells, thereby extending the service life of the liquid cooling plate and related components, while reducing the cost of maintenance and replacement. In addition, the configuration of the plurality of groups of assembly units offers high flexibility, allowing adjustment of the quantity and positioning of assembly units according to the specific dimensions and layout of battery packs, so as to meet the thermal management requirements of different vehicle models and battery configurations.

Referring to FIG. 3 and FIG. 5 , in some embodiments, in order to enable the elastic elements 3 to more evenly distribute external pressure, in two adjacent groups of assembly units 2, the first positioning ribs 21 of one group of assembly units 2 are arranged on the first major surface 12, and the first positioning ribs 21 of the other group of assembly units 2 are arranged on the second major surface 13, that is, the first positioning rib 21 of the two adjacent groups of assembly units 2 is arranged on different major surfaces, so as to ensure that the elastic element 3 assembled between the first positioning ribs 21 can also be arranged on different major surfaces, thereby avoiding deformation or damage caused by excessive pressure on one side, and improving the overall stability and durability of the structure. In addition, the alternating arrangement of the first positioning ribs on different major surfaces can increase the lateral rigidity of the plate body, mitigate deformation of the liquid cooling plate caused by battery cell expansion, and preserves the integrity of the liquid cooling channels while ensuring smooth coolant flow, thereby improving the cooling efficiency.

Based on the structural configuration where the assembly unit 2 includes two first positioning ribs 21 and one second positioning rib 22, the second positioning rib 22 is arranged opposite to the first positioning rib 21 in the same assembly unit 2, so as to facilitate the positioning and installation of the elastic element 3.

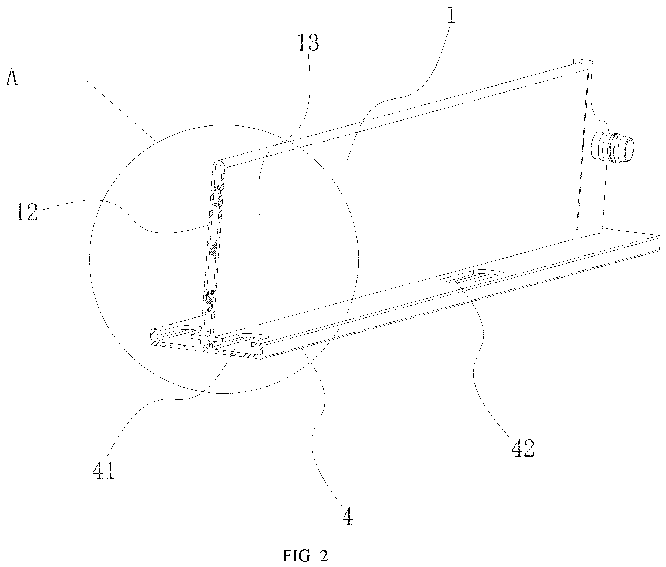

Referring to FIGS. 2 to 7, in some embodiments, the elastic element 3 is a rubber strip 31 or an elastic sheet 32. In some embodiments, the rubber strip 31 can be either a solid rubber strip 31 or a hollow rubber strip 31, as long as they can provide adequate support to the plate body 1. The elastic sheet 32 can be made of elastic and chemically stable metal or alloy materials, such as stainless steel. In some embodiments, the cross section of the elastic element 3 (i.e., the rubber strip 31 or the elastic sheet 32) is triangular, and a snap-fit groove 33 is provided at top corner of the elastic element 3's triangular cross-sectional profile to cooperate with the second positioning rib 22, while the other two corners of the elastic element 3's triangular cross-sectional profile abut respectively against the two first positioning ribs 21 for positioning. In addition, the elastic element 3 can be provided as a whole with a length equal to the length of the first positioning rib 21; Further, in an alternative embodiment, it can be configured that a plurality of shorter elastic elements 3 is discontinuously provided between the two first positioning ribs 21, provided that adequate support for the plate body 1 is maintained. The optional use of rubber strips or elastic sheets offers a diverse range of material and geometric configurations for elastic elements, which allows selection of the most suitable material based on specific liquid cooling plate designs and application environments, in order to meet customized requirements for thermal management and mechanical strength requirements.

Referring to FIGS. 1 to 7, in some embodiments, in order to facilitate attachment of the battery cell 5 to the liquid cooling plate, a pressure relief plate 4 is provided on at least one side of the bottom of the plate body 1. The pressure relief plate 4 includes a pressure relief channel 41 and an exhaust port 42. The pressure relief channel 41 is provided in the pressure relief plate 4, and the exhaust port 42 is provided at the top of the pressure relief plate 4, establishing communication between the top of the pressure relief plate 4 and the external environment. In some embodiments, the pressure relief cavity of the battery cell 5 is provided corresponding to the exhaust port 42. When exhaust and/or pressure relief is required, the gas passes through the pressure relief cavity, the exhaust port 42, and the pressure relief channel 41 to the outside of the liquid cooling plate in sequence, so as to avoid the accumulation of hot gas and cause the internal temperature of the battery pack to continue to rise, thereby reducing the risk of thermal runaway.

In some embodiments, in order to meet the requirement of arrangement of battery cells 5 on both sides of the liquid cooling plate, pressure relief plates 4 are respectively provided on both sides of the bottom of the plate body 1. The bilateral pressure relief plate 4 design allows the liquid cooling plate to better adapt to battery packs of different sizes and layouts, thereby enhancing the system's adaptability and versatility.

In some embodiments, a plurality of exhaust ports 42 are provided, and the plurality of exhaust ports 42 are arranged along the length direction of the pressure relief channel 41. By arranging a plurality of exhaust ports 42, the exhaust ports 42 can be arranged as needed, so as to correspond to the arrangement of the pressure relief valve of the battery cell 5, optimizing the thermal management of the battery to prevent overheating-induced performance degradation or safety risks. The spacing between the plurality of exhaust ports 42 can be set as needed. In some embodiments, equidistant spacing is adopted to simplify the use of battery cells 5 of the same specifications and streamline battery pack design and production. With the above arrangement, the plurality of exhaust ports can release the pressure generated by battery expansion inside the battery pack more quickly and evenly, prevent local pressure from being too high, help maintain the pressure balance inside and outside the battery pack, and reduce the physical impact on the liquid cooling plate. In addition, increased exhaust ports facilitate timely expulsion of heat generated during charging inside the battery pack, lowering the battery pack temperature to optimize thermal management and avoid battery performance degradation or safety problems caused by overheating.

## Claims

1. A liquid cooling plate, configured to dissipate heat from a battery cell, comprising a plate body (1), wherein the plate body (1) has a cavity forming a liquid cooling flow channel (11), wherein an elastic element (3) is arranged in the liquid cooling flow channel (11), wherein one side of the elastic element (3) is attached to an inner wall of one side of the plate body (1), and the elastic element (3) protrudes in a direction away from the side of the inner wall that the elastic element (3) is attached to.

2. The liquid cooling plate according to claim 1, wherein the elastic element (3) respectively abuts against two opposite inner walls of the plate body (1), thereby dividing the liquid cooling flow channel (11) into two independent cavities.

3. The liquid cooling plate according to claim 1, wherein an inner wall of the plate body (1) is provided with an assembly unit (2), and the assembly unit (2) comprises two first positioning ribs (21), the two first positioning ribs (21) are arranged along the length direction of the liquid cooling flow channel (11), and the two first positioning ribs (21) are arranged on a same inner wall of the plate body (1), and an elastic element (3) is arranged between the two first positioning ribs (21), and the elastic element (3) respectively abuts against the inner wall where the first positioning rib (21) is located and an opposite inner wall of the plate body (1).

4. The liquid cooling plate according to claim 3, wherein the inner wall of the plate body (1) has a first major surface (12) and a second major surface (13) arranged opposite to each other, and the two first positioning ribs (21) are both arranged on the first major surface (12) or the second major surface (13).

5. The liquid cooling plate according to claim 4, wherein the vertical distance between the first major surface (12) and the second major surface (13) is set to B, the thickness of the battery cell adjacent to the plate body (1) is T, and the maximum height of the first positioning rib (21) is H, then H=B-T*3%.

6. The liquid cooling plate according to claim 4, wherein the assembly unit (2) further comprises a second positioning rib (22), wherein the two first positioning ribs (21) is arranged on one of the first major surface (12) and the second major surface (13), while the second positioning rib (22) is arranged on the other one of the first major surface (12) and the second major surface (13), and the second positioning rib (22) and the two first positioning ribs (21) are staggered, and the elastic element (3) is provided with a snap-fit groove (33) on the side facing the second positioning rib (22), and the second positioning rib (22) is snap-fitted with the snap-fit groove (33).

7. The liquid cooling plate according to claim 6, wherein the second positioning rib (22) is equidistant from the two first positioning ribs (21).

8. The liquid cooling plate according to any one of claims 4 to 7, wherein the inner wall of the plate body (1) is provided with a plurality of groups of the assembly units (2) along the height direction of the plate body (1).

9. The liquid cooling plate according to claim 8, wherein, in two adjacent groups of the assembly units (2), the first positioning ribs (21) of one group of the assembly units (2) are arranged on the first major surface (12), and the first positioning ribs (21) of the other group of the assembly units (2) are arranged on the second major surface (13).

10. The liquid cooling plate according to claim 1, wherein the elastic element (3) is a rubber strip (31) or an elastic sheet (32).

11. The liquid cooling plate according to claim 1, wherein a pressure relief plate (4) is provided on at least one side of the bottom of the plate body (1), the pressure relief plate (4) comprises a pressure relief channel (41) and an exhaust port (42), the pressure relief channel (41) is provided in the pressure relief plate (4), and the exhaust port (42) is provided at top of the pressure relief plate (4), establishing communication between the top of the pressure relief plate (4) and external environment.

12. The liquid cooling plate according to claim 11, wherein the pressure relief plates (4) are respectively arranged on both sides of the bottom of the plate body (1).

13. The liquid cooling plate according to claim 11 or 12, wherein the pressure relief plate (4) comprises a plurality of the exhaust ports (42), and the plurality of the exhaust ports (42) are arranged along the length direction of the pressure relief channel (41).

14. The liquid cooling plate according to claim 3, wherein the elastic element (3) is assembled between the two first positioning ribs (21) via a plug-in engagement method.

15. The liquid cooling plate according to claim 3, wherein the two first positioning ribs (21) are arranged in parallel.
